# EUROPÄISCHE PATENTANMELDUNG

(11) **EP 1 705 710 A1**
(43) Veröffentlichungstag der Anmeldung: **27.09.2006**
(21) Anmeldenummer: 06005771.8
(22) Anmeldetag: 21.03.2006
(51) Int. Cl.: H01L 29/737, H01L 21/331

(54) **Bipolartransistor und Herstellungsverfahren dieses Transistors**

(30) Priorität: 26.03.2005 DE 102005013982
(71) Anmelder: ATMEL Germany GmbH, 74072 Heilbronn (DE)
(72) Erfinder: Berntgen, Jürgen, 74906 Bad Rappenau (DE); Brandl, Peter, 9500 Villach (AT); Dudek, Volker, 74336 Brackenheim (DE); Joodaki, Mojtaba, 81735 München (DE)

(57) **Zusammenfassung**

Die vorliegende Erfindung betrifft einen Bipolartransistor und ein Verfahren zur Herstellung eines derartigen Bipolartransistors mit folgenden Verfahrensschritten:Dotieren eines Oberflächenbereiches (3) eines Substrates (1) zum Bilden eines aktiven Emittergebietes mit einer ersten Dotierung; Bilden mindestens einer Kavität (6, 7) in dem Substrat (1); Aufbringen einer dielektrischen Isolationsschicht (8) auf der Oberfläche der mindestens einen Kavität (6, 7) in dem Substrat; Bilden eines zusammenhängenden Basisbereiches (15) mit einer zweiten Dotierung sowohl in der mindestens einen Kavität (6, 7) zum Vorsehen eines von den Substrat durch die dielektrische Isolationsschicht (8) elektrisch isolierten Basisanschlussbereiches (15b) als auch zumindest teilweise auf dem gebildeten aktiven Emittergebiet zum Vorsehen eines mit dem Substrat (1) elektrisch verbundenen Basisgebietes (15a); und Bilden eines Kollektorgebietes (16) mit einer dritten Dotierung zumindest auf dem gebildeten Basisgebiet (15a) zum Vorsehen eines mit dem gebildeten Basisgebiets (15a) elektrisch verbundenen Kollektors (16, 17).

## Beschreibung

Die vorliegende Erfindung betrifft ein Verfahren zur Herstellung eines Bipolartransistors und einen nach einem derartigen Verfahren hergestellten Bipolartransistor.

Die Bauelemente-Modellierung von auf einem Halbleitersubstrat integrierten Bauteilen nimmt mit steigender Betriebsfrequenz eine immer größer werdende Rolle ein, da in diesem Fall die Leitungseigenschaften, die Reflektionen an Diskontinuitäten, das Überlappen und die Verlustleistung zunehmen. Somit ist eine Berücksichtigung dieser Effekte in der Modellierung, insbesondere im Hochfrequenzbereich, im Allgemeinen unerlässlich. Insbesondere bei einem niederohmigen Substrat, wie beispielsweise einem SiliziumSubstrat, ist der parasitäre Einfluss der Substratleitfähigkeit und zusätzlicher Kapazitäten nicht zu vernachlässigen.

Ein Bipolartransistor ist im Allgemeinen ein Transistor mit zwei pn-Übergängen, dem Emitter und dem Kollektor, welche über ein gemeinsames schmales Mittelgebiet, die Basis, miteinander verbunden sind, und welcher auf der Injektion von Minoritätsträgern eines pn-Übergangs, im Allgemeinen der Emitter, in den Basisraum, dem Transport dieser Träger durch dieses Gebiet und der Kollektion, das heißt der Ansammlung dieser Ladungsträger am Kollektor-Übergang beruht. Am Transport sind sowohl Minoritäts- als auch Majoritätsträger beteiligt. Je nach der Reihenfolge des Ladungstyps der drei aufeinanderfolgenden Halbleitergebiete unterscheidet man zwischen pnp- und npn-Transistoren.

Im normalen Betriebszustand, wie er beispielsweise für den Verstärkereinsatz vorliegt, wird der Emitter-pn-Übergang in Flussrichtung und der Kollektor-Basis-pn-Übergang in Sperrrichtung betrieben.

Auch die umgekehrte, das heißt inverse Betriebsrichtung ist möglich, wird jedoch seltener verwendet. Dabei fließen zum Beispiel beim npn-Transistor Elektronen vom Emitter ins Basisgebiet und eine Injektion von Minoritätsträgern liegt vor. In diesem Gebiet rekombiniert ein Teil der Elektronen mit den dort vorhandenen Löchern, den sogenannten Majoritätsträgern, der größere Teil der Elektronen erreicht jedoch den nahe am Emitter-Übergang liegenden Kollektor-Übergang durch sogenannte Diffusion und/oder Drift und wird von dort als Strom über den Kollektoranschluss abgesaugt. Der Basisstrom bewirkt eine Steuerung des Kollektor-Stromes.

Im Grundstromkreis, mit der Basis als gemeinsamer Bezugselektrode, erzeugt beispielsweise eine kleine Änderung der Emitter-Basis-Spannung, eine kräftige Emitterstromänderung, welche sich nahezu ungeschmälert auf den Kollektorstrom überträgt und am Lastwiderstand eine entsprechend große Kollektorspannungsänderung erzeugt. Auf diese Weise kommt eine Verstärkung der Spannungsänderung zustande. Daher wird dieses Änderungsverhalten häufig auch mit dem Begriff "aktives Bauelement" beschrieben.

Je nach den geometrischen Abmessungen, den Materialeigenschaften, der elektrischen Bemessung, den Herstellungsverfahren und der vorgesehenen Anwendung ergibt sich eine große Variationsbreite von Bipolartransistoren.

Für Hochfrequenzanwendungen werden häufig sogenannte Hetero-Bipolar-Transistoren (HBT) verwendet, bei welchen mindestens der Emitter-Basis-Übergang als Hetero-pn-Übergang ausgeführt ist. Beim HBT wird die Höhe der erzielbaren Stromverstärkung unter anderem durch den Emitterwirkungsgrad begrenzt. Ein guter Emitterwirkungsgrad verlangt jedoch eine hohe Emitterdotierung und/oder einen hohen Basiswiderstand. Weit verbreitete Materialsysteme sind beispielsweise Silizium-Germanium(Si-Ge)-Emitterübergänge.

Somit besteht allgemein der Wunsch, Hetero-Bipolar-Transistoren und deren Herstellungsverfahren, insbesondere SiGe-HBTs zu verbessern und die Leistung für Hochfrequenzanwendungen zu steigern. Zudem sollen die Herstellungskosten derartiger HBTs verringert werden.

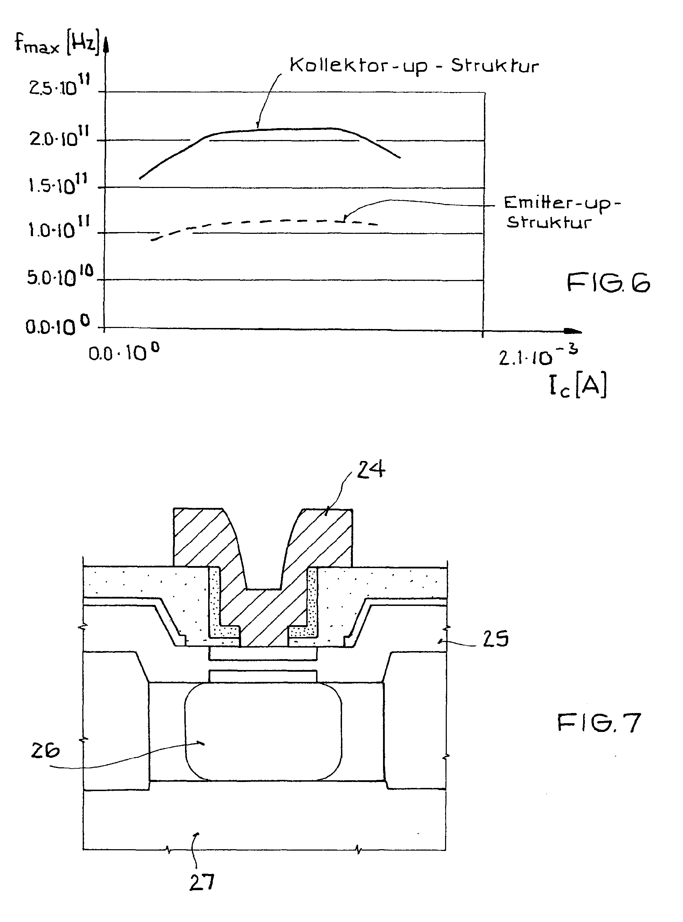

Fig. 7 illustriert eine schematische Querschnittsansicht eines Standard SiGe-HBTs mit einer sogenannten Emitter-up-Struktur, das heißt einer Struktur, bei welcher der Emitter 24 oberhalb des Substrates und oberhalb der Basis 25 in dem Transistor eingebaut ist. Wie ferner in Fig. 7 ersichtlich ist, ist der selektiv implantierte Kollektor (so genannte SIC-Implantation) in dem Substrat integriert.

Diese Emitter-up-Struktur wird üblicherweise realisiert, da in einem Bipolartransistor sehr niedrige Emitter- und Kollektorwiderstände benötigt werden. Beispielsweise wird der Emitter hoch dotiert und der Kollektor wird durch eine mit Arsen n-dotierte Schicht 27, wie in Fig. 7 ersichtlich ist, realisiert. Dieser Aufbau ermöglicht einen akzeptablen Kollektorwiderstand.

An diesem Ansatz gemäß dem Stand der Technik hat sich jedoch die Tatsache als nachteilig herausgestellt, dass einerseits der Kollektorwiderstand zwar verringert wird, jedoch noch keine zufriedenstellenden Widerstandswerte liefert. Zudem werden die verringerten Widerstandswerte nur dadurch auf Kosten einer erhöhten Kollektor-Basis-Kapazität und einer erhöhten Kollektor-Substrat-Kapazität erzielt, was sich wiederum nachteilig auf die HF-Eigenschaften auswirkt.

Es ist gemäß einem weiteren Stand der Technik bekannt, eine silizidierte Schicht mit einem niedrigen Widerstand anstelle der mit Arsen n-dotierten Schicht zu implementieren, wodurch ein geringerer Widerstand geliefert wird. Dadurch kann ein Kollektor-up-Transistor, das heißt ein Transistor mit einem oberhalb der Basis und dem Substrat implementierten Kollektor, mit einem niedrigen Emitterwiderstand realisiert werden. Da in diesem Fall der Emitter unterhalb des Kollektors angeordnet ist und höher dotiert als der Kollektor sein kann, wird ein mit Phosphor hoch n-dotierter Bereich verwendet. Zusätzlich ist der Emitterkontakt in Nähe des hoch n-dotierten Bereichs angeordnet, und dies verhindert einen sogenannten kapazitiven Tiefenanteil, was wiederum in einem geringen Widerstand resultiert.

Gemäß einem weiteren Stand der Technik ist es bekannt, einen Emitter-up-SiGe-Hetero-Bipolar-Transistor herzustellen, welcher verbesserte Leistungseigenschaften aufweist.

Allerdings hat sich an den oben genannten Ansätzen gemäß dem Stand der Technik jedoch die Tatsache als nachteilig herausgestellt, dass das verwendete Herstellungsverfahren kostspielig und aufwendig ist. Zudem ist bei den obigen Ansätzen zwischen dem Emitter und der Basis keine lsolationsschicht vorgesehen, so dass die Emitter-Basis-Kapazität nachteilig einen sehr hohen Wert annimmt.

Somit ist es Aufgabe der vorliegenden Erfindung, ein Herstellungsverfahren für einen Bipolartransistor und einen durch ein derartiges Herstellungsverfahren geschaffenen Bipolartransistor bereitzustellen, wodurch die oben genannten Nachteile beseitigt und insbesondere ein einfacheres und kostengünstigeres Verfahren zur Herstellung eines Bipolartransistors mit einem niedrigen Basiswiderstand, niedrigen Kapazitäten und verringerten parasitären Verlusten gewährleistet werden.

Diese Aufgabe wird erfindungsgemäß verfahrensseitig durch das Verfahren mit den Merkmalen des Patentanspruchs 1 und gegenstandsseitig durch den Bipolartransistor mit den Merkmalen des Patentanspruchs 19 gelöst.

Die der vorliegenden Erfindung zugrunde liegende Idee besteht darin, dass ein Oberflächenbereich eines Halbleitersubstrates zum Bilden eines aktiven Emittergebietes mit einer ersten Dotierung dotiert wird; anschließend mindestens eine Kavität in dem Substrat gebildet wird; eine dielektrische Isolationsschicht auf der Oberfläche der mindestens einen Kavität in dem Halbleitersubstrat aufgebracht wird; ein zusammenhängender Halbleiter-Basisbereich mit einer zweiten Dotierung sowohl in der mindestens einen Kavität zum Vorsehen eines von dem Halbleitersubstrat durch die dielektrische Isolationsschicht elektrisch isolierten Basisanschlussbereiches als auch zumindest teilweise auf dem gebildeten aktiven Emittergebiet zum Vorsehen eines mit dem Halbleitersubstrat elektrisch verbundenen Basisgebietes gebildet wird; und dass ein Halbleiterkollektorgebiet mit einer dritten Dotierung zumindest auf dem gebildeten Basisgebiet zum Vorsehen eines mit dem gebildeten Basisgebiet elektrisch verbundenen Kollektors gebildet wird.

Somit wird durch ein einfaches und kostengünstiges Herstellungsverfahren ein Bipolartransistor hergestellt, bei welchem eine Kollektor-up-Struktur gewährleistet wird und eine elektrische Isolierung zwischen dem Basisanschlussbereich und dem Substrat bzw. dem Emitter erzeugt wird.

Somit weist die vorliegende Erfindung gegenüber den Ansätzen gemäß dem Stand der Technik den Vorteil auf, dass die auftretenden parasitären Kapazitäten und somit die parasitären Verluste verringert werden. Zudem kann der Basisanschlussbereich mit einer vergrößerten Breite derart ausgebildet werden, dass der elektrische Widerstand desselben vorteilhaft verringert wird. Die parasitäre Substratkapazität wird durch die elektrische Entkopplung von den Basisanschlussbereichen vollständig ausgelöscht, der Basiswiderstand, wie oben erläutert, wird verringert und die Kollektor-Basis-Kapazität wird vorteilhaft durch die Kollektor-up-Struktur verringert. Der erfindungsgemäße Bipolartransistor weist somit verbesserte Gleichspannungs- und Wechselspannungscharakteristiken auf. Die Widerstände der Basis und des Emitters werden durch den erfindungsgemäßen Bipolartransistor auf einfache und kostengünstige Weise verringert und die parasitären Verluste ohne eine Verringerung der maximalen Frequenz des Bipolartransistors ausgeschaltet.

In den Unteransprüchen finden sich weitere vorteilhafte Ausgestaltungen und Verbesserungen des im Patentanspruch 1 angegebenen Verfahrens und des im Patentanspruch 19 angegebenen Bipolartransistors.

Gemäß einer bevorzugten Weiterbildung werden der Basis-Emitter-Übergang und/oder der Basis-Kollektor-Übergang jeweils als Heterostruktur, beispielsweise als Hetero-pn-Übergang zum Bilden eines Hetero-Bipolar-Transistors (HBT), insbesondere eines Silizium-Germanium HBTs, ausgebildet. SiGe-HBTs sind insbesondere im Hochfrequenzbereich vorteilhafte Transistoren mit guten Charakteristiken. Die HBTs weisen gute Emitterwirkungsgrade auf und besitzen ihre Vorteile hauptsächlich im Hochfrequenzbereich, da ihre Grenzfrequenzen weit über 100 GHz liegen können.

Gemäß einem weiteren bevorzugten Ausführungsbeispiel ist das Substrat als Silizium-Halbleitersubstrat ausgebildet. Es ist für einen Fachmann offensichtlich, dass auch andere Substratmaterialien verwendet werden können, jedoch ist ein Siliziumsubstrat ein gängiges und auf billige Weise herstellbares Substrat mit guten Eigenschaften.

Der dotierte Oberflächenbereich des Substrates weist eine erste Dotierung auf, welche vorzugsweise niedrig n-dotiert wird, beispielsweise durch Implantation von Phosphor. Nach einer weiteren bevorzugten Weiterbildung wird ein vorbestimmter Bereich des Substrates unterhalb des dotieren Oberflächenbereiches hoch n-dotiert, beispielsweise durch wiederum Implantation von Phosphor. Selbstverständlich können auch andere Implantationsmaterialien verwendet werden, jedoch erweist sich Phosphor in dem vorliegenden Anwendungsfall als besonders vorteilhaft.

Gemäß einer weiteren bevorzugten Ausführungsform werden eine erste dielektrische Schicht über der Substratoberfläche und eine erste Indikationsschicht, beispielsweise eine Nitridschicht, mit vorbestimmter Dicke über der ersten dielektrischen Schicht gebildet. Dies wird vorzugsweise vor dem Aufbringen der dielektrischen Isolationsschicht in der Kavität in dem Substrat ausgeführt.

Vorteilhaft wird das Substrat anschließend zum Bilden der mindestens einen Kavität zurückgeätzt, beispielsweise mittels eines isotropen Trockenätzverfahrens. Insbesondere werden zwei voneinander beabstandete Kavitäten in dem Substrat gebildet.

Nach dem Bilden der Kavität bzw. Kavitäten wird die dielektrische Isolationsschicht über dem Substrat zum Bilden der dielektrischen Isolationsschicht auf der Oberfläche der Kavität bzw. Kavitäten vorzugsweise gebildet.

Nach einer weiteren bevorzugten Weiterbildung werden die erste dielektrische Schicht und die dielektrische Isolationsschicht sowie die erste Indikationsschicht zum Bilden von Aufwachsbereichen zum Aufwachsen des zusammenhängenden Basisbereiches strukturiert, wobei anschließend vorzugsweise nach dem Bilden der Aufwachsbereiche eine hoch p-dotierte Silizium-Basisschicht mit der zweiten Dotierung über der Anordnung unter Zuhilfenahme der gebildeten Aufwachsbereiche zum Bilden des zusammenhängenden Basisbereiches in der Kavität bzw. den Kavitäten zum Vorsehen des elektrisch isolierten Basisanschlussbereiches als auch zumindest teilweise auf dem gebildeten aktiven Emittergebiet zum Vorsehen des Basisgebietes aufgewachsen wird, beispielsweise mittels eines Epitaxieverfahrens.

Die aufgewachsene Siliziumschicht und die dielektrische Isolationsschicht werden vorteilhaft bis auf Höhe der ersten Indikationsschicht zurückgeätzt, beispielsweise mittels eines CMP-Verfahrens. Somit wird verhindert, dass eine weitere Zurückätzung die gebildeten notwendigen Strukturen wegätzt. Die erste Indikationsschicht dient somit einem Anzeigen, dass der zurückzuätzende Bereich durch den Ätzvorgang in ausreichendem Maße zurückgeätzt wurde.

Nach einem weiteren bevorzugten Ausführungsbeispiel werden die erste Indikationsschicht und die erste dielektrische Schicht auf dem gebildeten aktiven Emittergebiet entfernt, beispielsweise durch vorherige Strukturierung mittels einer photoresistiven Schicht.

Gemäß einer weiteren bevorzugten Ausführungsform wird nach dem Entfernen der ersten Indikationsschicht eine p-dotierte Silizium-Germanium-Basisschicht über der Anordnung aufgebracht. Nach dem Aufwachsen der Silizium-Germanium-Schicht wird vorzugsweise eine n-dotierte Silizium-Kollektorschicht mit der dritten Dotierung über der Anordnung aufgewachsen und anschließend wiederum bis auf Höhe der ersten Indikationsschicht zurückgeätzt, beispielsweise mittels eines isotropen Trockenätzverfahrens. Die erste Indikationsschicht dient analog einem Anzeigen, dass der zurückzuätzende Bereich bis auf die gewünschte Form zurückgeätzt worden ist.

Nach dem Aufwachsen der n-dotierten Siliziumschicht wird beispielsweise eine zweite dielektrische Schicht, beispielsweise ein Siliziumoxid, über der Anordnung aufgebracht. Nach dem Aufbringen der zweiten dielektrischen Schicht wird diese mit Ausnahme von seitlichen Isolationsabstandshaltern bis auf die Höhe der ersten Indikationsschicht strukturiert entfernt, beispielsweise mittels eines isotropen Ätzverfahrens.

Anschließend werden vorteilhaft geeignete Metallisierungen zum Bilden von Anschlusskontakten des Emitters, der Basis und des Kollektors unter Zuhilfenahme der seitlichen Isolationsabstandshalter gebildet. Dabei können gängige Metallisierungsverfahren verwendet werden.

Gemäß einem weiteren bevorzugten Ausführungsbeispiel wird die direkt auf dem Substrat aufgewachsene hoch p-dotierte Siliziumschicht silizidiert, beispielsweise mittels Implantation von Phosphor. Dieser Schritt kann vorzugsweise am Ende des Herstellungsverfahrens oder zu einem früheren Zeitpunkt durchgeführt werden.

Nachfolgend werden bevorzugte Ausführungsbeispiele der vorliegenden Erfindung unter Bezugnahme auf die Figuren der Zeichnung näher erläutert. Von die Figuren zeigen:
- Figuren 1a - 1p: Querschnittsansichten eines exemplarischen Bipolartransistors in verschiedenen Verfahrenszuständen zur Darstellung der einzelnen Verfahrensschritte gemäß einem bevorzugten Ausführungsbeispiel der vorliegenden Erfindung;
- Figur 2: schematische Darstellungen von Gummel-Kurven für eine Kollektor-up-Struktur und eine Emitter-up-Struktur;
- Figur 3: eine schematische Darstellung von simulierten Stromverstärkungskurven für einen Kollektor-up-Transistor und einen Emitter-up-Transistor;
- Figur 4: eine schematische Darstellung von simulierten MSG-Kurven für eine Kollektor-up-Struktur und eine Emitterup-Struktur;
- Figur 5: eine schematische Darstellung der simulierten Durchgangsfrequenzen einer Kollektor-up-Struktur und einer Emitter-up-Struktur;
- Figur 6: eine schematische Darstellung der simulierten maximalen Oszillationsfrequenzen einer Kollektor-up-Struktur und einer Emitter-up-Struktur; und
- Figur 7: eine schematische Querschnittsansicht eines Bipolartransistors mit einer Emitter-up-Struktur gemäß dem Stand der Technik.

In den Figuren bezeichnen gleiche Bezugszeichen gleiche oder funktionsgleiche Komponenten - soweit nichts Gegenteiliges angegeben ist.

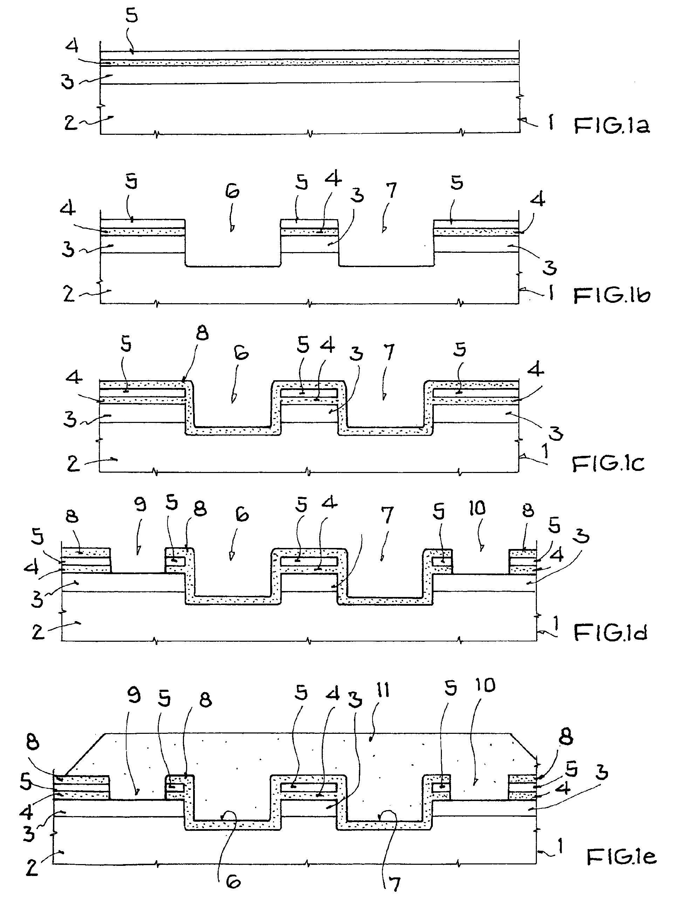

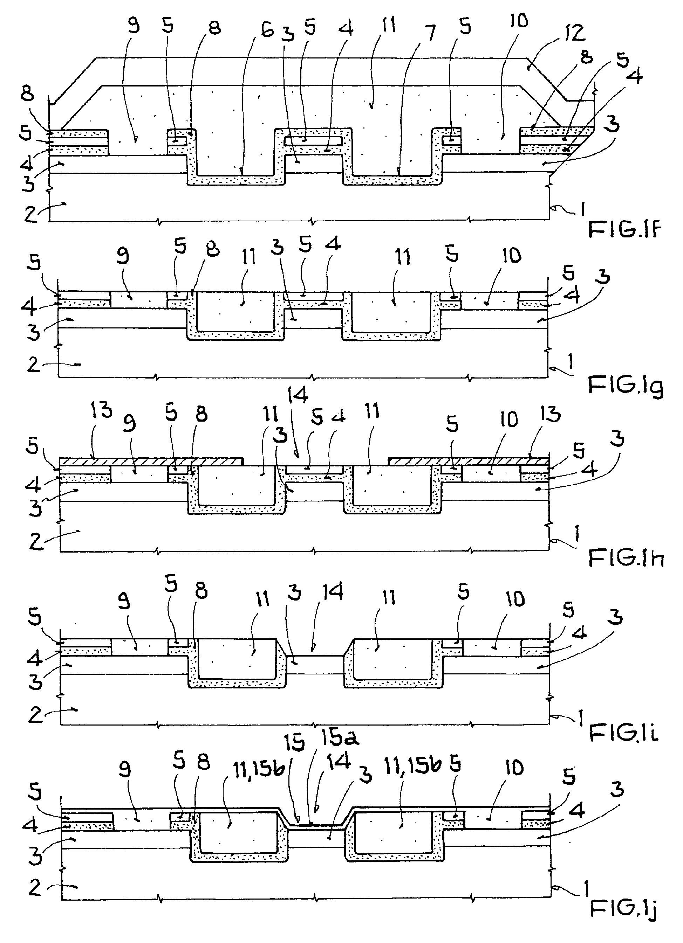

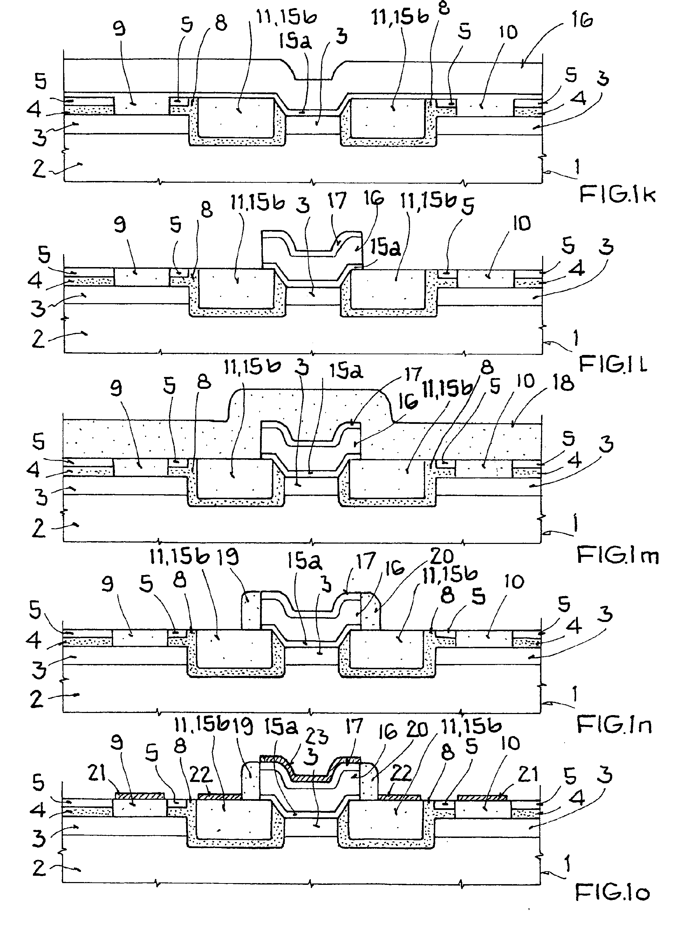

Figuren 1a bis 1p illustrierten Querschnittsansichten eines exemplarischen Bipolartransistors in verschiedenen Verfahrenszuständen zur Darstellung der einzelnen Verfahrensschritte, wobei anhand der Figuren 1a bis 1p ein Herstellungsverfahren eines Bipolartransistors gemäß einem bevorzugten Ausführungsbeispiel der vorliegenden Erfindung näher erläutert wird.

Wie in Fig. 1a ersichtlich ist, wird zunächst in einem Substrat 1, beispielsweise in einem gängigen Siliziumsubstrat, eine hoch n-dotierte Schicht 2 gebildet, die später u.a. als Emitter dienen soll. Beispielsweise wird zum Bilden der hoch n-dotierten Schicht 2 Phosphor mittels eines geeigneten lmplantationsverfahrens implantiert. Eine Phosphorimplantation schafft einen geringeren elektrischen Widerstand, jedoch eine höhere Diffusionskonstante bezüglich des Dotierens. Dies erfordert einen dicker ausgebildeten Emitter, um einen Emitter mit einer niedrigen Dotierungskonzentration an dem Emitter-Basis-Übergang zu schaffen. Die Implantation von Phosphor kann beispielsweise auch zu einem späteren Zeitpunkt während des Herstellungsverfahrens ausgeführt werden, dies könnte jedoch die Bildung der Basis und des Kollektors nachteilig beeinflussen.

Vorzugsweise, wie in Fig. 1a illustriert ist, weist die n-dotierte Siliziumschicht zusätzlich zu dem unteren hoch n-dotierten Siliziumbereich 2 einen niedrig n-dotierten Bereich 3 auf. Dies wird analog zu dem oben Gesagten vorzugsweise durch eine geeignete Implantation von beispielsweise Phosphor erreicht.

Die Dicke der Siliziumschicht beträgt beispielsweise 250 nm, wobei die Dicke derart vorteilhaft gewählt ist, dass sowohl dicke externe Basisanschlussbereiche als auch ein Emitter mit einer niedrigen Dotierungskonzentration von ungefähr 3 x10¹⁸ cm⁻³ an dem Basis-Emitterübergang erreicht werden können.

Nachfolgend, wie ebenfalls in Fig. 1a dargestellt ist, wird eine dünne Oxidschicht 4 über dem Substrat 1 bzw. auf dem niedrig n-dotierten Bereich 3 des Substrates 1 gebildet. Dies kann beispielsweise mittels eines thermischen Verfahrens erfolgen, wobei die gebildete dünne Oxidschicht 4 zum Beispiel eine Dicke von 20 nm aufweist und als Siliziumoxidschicht auf dem Substrat 1 aufgewachsen wird.

Wie in Fig. 1a ferner gezeigt ist, wird anschließend auf der dünnen Oxidschicht 4, die als erste dielektrische Schicht 4 dient, eine Indikationsschicht 5 aufgebracht. Die Indikationsschicht 5 ist beispielsweise als Nitridschicht 5 ausgebildet und weist eine Dicke von vorzugsweise 100 nm auf. Das Nitrid wird beispielsweise mittels eines hinlänglich bekannten Abscheidungsverfahrens auf der dielektrischen Schicht 4 abgeschieden.

Als nächstes wird, wie in Fig. 1b dargestellt ist, das Substrat 1 strukturiert und die erste dielektrische Schicht 4, die Indikationsschicht 5 sowie das Silizium an vorzugsweise zwei vorbestimmten Bereichen zum Bilden von Kavitäten 6 und 7 zurückgeätzt. Als Ätzverfahren kann beispielsweise ein hinlänglich bekanntes isotropes Trockenätzverfahren verwendet werden. Wie in Fig. 1b zudem ersichtlich ist, sind die beiden zurückgeätzten Kavitäten 6 und 7 durch einen Brückenbereich voneinander getrennt, welcher letztendlich als aktiver Bereich des Bipolartransistors dient.

Fig. 1c illustriert einen weiteren Verfahrensschritt. Es wird eine weitere Oxidschicht 8, vorteilhaft eine Siliziumoxidschicht, über der Anordnung, das heißt über der verbliebenen Nitridschicht 5 und auf den Oberflächen der Kavitäten 6 und 7 gebildet. Die Oxidschicht 8 dient als dielektrische Isolationsschicht 8.

Beispielsweise wird zum Bilden dielektrische Isolationsschicht 8 zunächst eine erste dünne Oxidschicht mit einer Dicke von beispielsweise 2 bis 3 nm mittels eines Temperaturverfahrens und anschließend darauf eine zweite dickere Oxidschicht mit einer Dicke von beispielsweise 100 nm mittels eines Plasmaverfahrens abgeschieden. Dies hat den Vorteil, dass die erste dünne Oxidschicht, welche mittels des thermischen Verfahrens zunächst abgeschieden wird, günstigere elektrische Charakteristiken bei dem Übergangsbereich Siliziumschicht-Oxidschicht aufweist. Anschließend kann mittels eines einfacheren und günstigeren Plasmaverfahrens diese Oxidschicht vorteilhaft zum Erreichen einer vorbestimmten Gesamtdicke verdickt werden. Somit wird schließlich die in Fig. 1c dargestellte Struktur geschaffen.

Anschließend wird in einem nächsten Verfahrensschritt, wie in Fig. 1d dargestellt ist, der Wafer bzw. die Oxidschichten 4 und 8 sowie die Nitridschicht 5 strukturiert und durch beispielsweise ein isotropes Trockenätzverfahren in vorbestimmten Bereichen 9 und 10 vollständig bis auf Höhe des Substrates 1 zurückgeätzt. Dadurch entstehen die in Fig. 1d dargestellten Aufwachsbereiche 9 und 10, welche vorzugsweise jeweils seitlich der beiden Kavitäten 6 und 7 angeordnet sind.

Nachfolgend wird gemäß Fig. 1e eine hoch p-dotierte kristalline Siliziumschicht 11 in den zuvor gebildeten Aufwachsbereichen 9 und 10 aufgewachsen und anschließend wird darauf in einem in-situ-Verfahren eine hoch p-dotierte Siliziumschicht wiederum aufgewachsen, sodass die in Fig. 1e dargestellte Struktur in etwa hergestellt wird. Dabei füllen die aufgewachsenen hoch p-dotierten Siliziumschichten sowohl die Aufwachsbereiche 9 und 10 als auch die Kavitäten 6 und 7. Es wird beispielsweise ein Silizium-Epitaxie zum Bilden der hoch p-dotierten Siliziumschicht aufgedampft.

Anschließend wird die gesamte Struktur mit einer zweiten Nitridschicht 12 bedeckt und unter Verwendung eines gängigen Ätzverfahrens für eine nachfolgende CMP(Chemical Mechanical Polishing)-Nachbehandlung strukturiert.

Anschließend erfolgt die CMP-Nachbehandlung, wobei die in Fig. 1 g dargestellte Struktur erreicht wird. Dabei dient die erste Nitridschicht 5 derart als Indikationsschicht 5, dass die zweite Nitridschicht 12, das aufgewachsene Silizium-Epitaxie 11 sowie die dielektrische Isolationsschicht 8 bis auf Höhe der ersten Nitridschicht 5 bzw. der Indikationsschicht 5 entfernt werden.

In einem nachfolgenden Verfahrensschritt wird gemäß Fig. 1h eine photoresistive Schicht 13 über der Struktur aufgebracht und in geeigneter Weise derart strukturiert, dass sie mit der in Fig. 1h dargestellten Form auf der Anordnung aufgebracht ist. Es ist insbesondere der zwischen den beiden Kavitäten 6 und 7 angeordnete aktive Bereich sowie ein daran angrenzender Bereich oberhalb eines Teils der Kavitäten 6, 7 nicht von der photoresistiven Schicht 13 bedeckt, wie in Fig. 1 h ersichtlich ist.

Nachfolgend werden beispielsweise mittels eines anisotropen Ätzverfahrens die zwischen den beiden Kavitäten 6 und 7 aufgebrachte erste dielektrische Schicht 4 und die erste Nitridschicht 5 in dem aktiven Bereich 14 gemäß der zuvor gebildeten Strukturierung der photoresistiven Schicht 13 entfernt. Anschließend wird die photoresistive Schicht 13 beispielsweise mittels Aceton oder eines Plasmaverfahrens entfernt, so dass die in Fig. 1i dargestellte Struktur geschaffen wird. Durch das anisotrope Ätzverfahren werden die Randbereiche des aktiven Bereichs 14 mit runden Kanten ausgebildet, wie in Fig. 1i ferner angedeutet ist. Diese Abrundung ist für das nachfolgende Bilden der inneren Basis 15a vorteilhaft.

Wie in Fig. 1j illustriert ist, wird über der Struktur nachfolgend eine p-dotierte Silizium-Germanium-Schicht 15 als Basisbereich aufgebracht. Beispielsweise wird dazu zunächst eine dünne 5 nm Silizium-Germanium-Schicht als Emitter-Basis-Abstandshalter ohne eine Dotierung aufgebracht, wobei anschließend darauf eine dickere mit Bor p-dotierte Silizium-Germanium-Schicht mit einer Dicke von beispielsweise 10 nm und darauf wiederum eine undotierte Silizium-Germanium-Schicht als Basis-Kollektor-Abstandshalter mit einer Dicke von beispielsweise 10 nm epitaxisch abgeschieden werden.

Diese drei vorab genannten Silizium-Germanium-Schichten bilden zusammen die in Fig. 1j dargestellte Silizium-Germanium-Schicht 15, welche einem Bilden des Basisbereiches dient. Die im aktiven Bereich 14 aufgebrachte Silizium-Germanium-Schicht 15 dient letztendlich als innerer Basisbereich 15a und die über den Kavitäten 6 und 7 abgeschiedene Silizium-Germanium-Schicht dienen als Bestandteil der äußeren Basiskontakte bzw. Basisanschlussbereiche 15b, wie in Fig. 1j exemplarisch dargestellt ist.

Vorzugsweise kann ein geringer Prozentsatz an Kohlenstoff-Konzentration zusammen mit der hohen Bor-Dotierung verwendet werden, um das Herausdiffundieren des Bors in Richtung des Emitters zu verhindern.

Fig. 1k illustriert einen nachfolgenden Verfahrensschritt, bei welchem über der Anordnung in Fig. 1j vorteilhaft eine Silizium-Epitaxie mit einer niedrigen n-Dotierung und einer homogenen Dicke aufgewachsen wird, so dass die in Fig. 1k dargestellte Struktur geschaffen wird.

Anschließend, wie in Fig. 11 illustriert ist, wird auf dem oberen Bereich des niedrig n-dotierten Silizium-Epitaxie 16 ein hoch n-dotierter Siliziumbereich 17 aufgewachsen, um gute Eigenschaften für einen Kollektoranschluss zu gewährleisten. Durch die hohe Dotierung wird der Widerstand in dem Bereich 17 für einen Kontaktanschluss des Kollektors vorteilhaft verringert. Dabei kann die Dotierung beispielsweise wiederum mittels einer Implantation von Phosphor, Arsen oder dergleichen erfolgen.

Wie in Fig. 1I ebenfalls ersichtlich ist, wird anschließend die aufgewachsene Silizium-Epitaxie 16, 17 mittels beispielsweise eines isotropen Trockenätzverfahrens zurückgeätzt. Dabei dient die erste Nitridschicht 5 wiederum als Indikationsschicht 5, welche dem Hersteller genau den Zeitpunkt der Rück-ätzung bis auf Höhe der Indikationsschicht 5 signalisiert. Beispielsweise kann der Anteil des Nitrids in der Ätzlösung analysiert werden, wobei anhand der Nitridkonzentration das Fortschreiten des Ätzvorgangs in Richtung der Nitridschicht 5 feststellbar ist. Somit kann die zurückgeätzte Schichtdicke bis auf Höhe der Nitridschicht genau geregelt werden.

In einem nachfolgenden Verfahrensschritt gemäß Fig. 1m wird eine zweite dielektrische Schicht 18, beispielsweise eine Siliziumoxidschicht, insbesondere eine Siliziumdioxidschicht, über der Struktur gebildet, wobei beispielsweise zunächst eine dünne Oxidschicht mit einer Dicke von beispielsweise 2 nm mittels eines thermischen Verfahrens und anschließend eine dickere Oxidschicht über der dünnen Oxidschicht abgeschieden wird. Die dickere Siliziumoxidschicht kann beispielsweise mittels eines Temperatur- oder eines Plasmaverfahrens abgeschieden werden, wobei dies mittels eines gängigen CVD(Chemical Vapor Deposition)-Verfahrens bewerkstelligt werden kann. Dabei wird die zweite dielektrische Schicht 18 vorzugsweise mit einer einheitlichen Dicke über der Struktur aufgebracht, wie in Fig. 1 m dargestellt ist.

Nachfolgend wird mittels beispielsweise eines isotropen Trockenätzverfahrens die zweite dielektrische Schicht 18 derart zurückgeätzt, dass seitlich des aufgewachsenen Silizium-Epitaxie 16, 17 jeweils ein Abstandshalter 19 bzw. 20 zurückbleibt, wie in Fig. 1n illustriert ist. Dadurch weist der als Kollektor dienende Bereich 16, 17 an beiden Seiten einen elektrisch isolierten Abstandhalter 19 bzw. 20 auf.

Wie in Fig. 1o dargestellt ist, werden geeignete Metallisierungen durch vorzugsweise gängige Aufdampfungs- und Strukturierungsverfahren auf der Struktur gebildet. Beispielsweise wird über den p-dotierten Siliziumbereichen in den Aufwachsbereichen 9 und 10 jeweils eine Emittermetallisierung 21, über den in den Kavitäten 6 und 7 aufgebrachten Siliziumschichten jeweils eine Basismetallisierung 22 und oberhalb der n-dotierten Silizium-Epitaxie 16, 17 eine Kollektormetallisierung 23 gebildet. Zur Bildung dieser Metallisierungen 21, 22 und 23 werden vorteilhaft die beiden dielektrischen Abstandshalterbereiche 19 und 20 für eine Salizidierung (Self-Aligned-Silicide = SALICIO; d.h. Salizid; d.h. Silizid entsteht nur selektiv und nicht ganzflächig) verwendet, wobei Titan beispielsweise abgeschieden und anschließend entsprechend strukturiert wird.

Abschließend, wie in Fig. 1p illustriert ist, erfolgt eine Phosphor-Implantation des in den beiden Aufwachsbereichen 9 und 10 epitaktisch gebildeten p-dotierten Siliziums, um Emitterkontakte in den Bereichen der Aufwachsbereiche 9 und 10 mit einem niedrigen elektrischen Widerstand zu gewährleisten. Dabei wird für die Silizidierung vorzugsweise ein RTA(Rapid Thermal Annealing)-Verfahren verwendet. Dieser Vorgang kann unter Umständen auch vorgezogen werden, sofern sich daraus vorteilhafte Charakteristiken durch die Temperierung ergeben. Jedoch ist eine einheitliche Silizidierung am Ende des Herstellungsverfahrens zu bevorzugen. Anstatt Phosphor kann selbstverständlich auch ein anderes Material zur Implantation verwendet werden, wie beispielsweise Arsenid.

Es sei an dieser Stelle darauf hingewiesen, dass die oben angegebenen Materialien, Schichtdicken sowie die Abfolge einzelner Verfahrensschritte modifiziert werden können, solange die in Fig. 1p dargestellte Struktur des Bipolartransistors erhalten wird. Zudem ist anstelle eines npn-Übergangs auf analoge Weise auch ein pnp-Übergang realisierbar, falls erwünscht.

Wie in Fig. 1p somit ersichtlich ist, schafft das vorliegende erfindungsgemäße Herstellungsverfahren einen Bipolartransistor, bei welchem eine Kollektor-up-Struktur gewährleistet wird, wobei der Emitter 1; 2, 3 von den externen Basisbereichen 15b durch die dielektrische Isolationsschicht 8 elektrisch isoliert ist. Dadurch wird ein BJT(Bipolar Junction Transistor, dt: bipolarer Sperrschichtstransistor)-Transistor gemäß dem Stand der Technik mit seinen hohen parasitären Verlusten verhindert und ein Bipolartransistor geschaffen, bei welchem die Dicke der Basisanschlüsse dick genug ist, um für einen vorteilhaften elektrischen Kontakt den Widerstand möglichst gering zu halten. Zudem wird durch die erfindungsgemäße Struktur des Bipolartransistors der Gleichspannungs- und Wechselspannungs-Leistungsgrad der Anordnung erhöht.

Mit dem vorliegenden Erfindungsgedanken kann ein Kollektor-up SiGe-Hetero-Bipolar-Transistor auf einem Substrat für Hochfrequenzanwendungen geschaffen werden, bei welchem zudem die parasitäre Basis-Emitter-Kapazität gegenüber den Bipolartransistoren gemäß dem Stand der Technik erheblich reduziert ist.

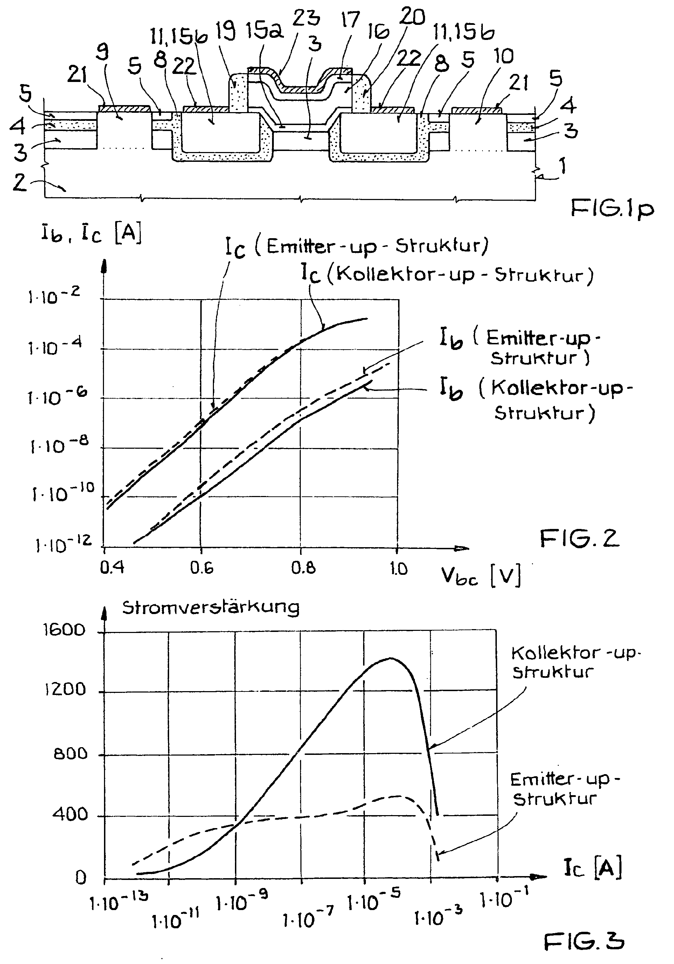

Im Folgenden werden unter Bezugnahme auf die Figuren 2 bis 6 die Vorteile eines erfindungsgemäßen und nach einem Herstellungsverfahren der vorliegenden Erfindung hergestellten Bipolartransistors im Vergleich zu einem Bipolartransistor gemäß dem Stand der Technik näher erläutert.

Es werden Gleichspannungs- und Wechselspannungssimulationen an einem erfindungsgemäßen Kollektor-up-Transistor und einem Emitter-up-Transistor gemäß dem Stand der Technik mit ähnlichen Materialeigenschaften und Modellparametern durchgeführt. Für einen aussagekräftigen Vergleich sind die Dotierungsprofile, der Germaniumgehalt sowie die geometrische Abmessungen für beide Strukturen gleich gewählt. Die einzigen Unterschiede bestehen darin, dass in dem Kollektor-up-Transistor der Kollektor 75 nm dünner ist und die SIC-Implantation nicht verwendet wird, und dass stattdessen eine einheitliche Phosphordotierung von 1 x 10¹⁷ cm⁻³ verwendet wird. Es ist bekannt, dass eine SIC-Implantation die Hochfrequenzleistungen verbessert, jedoch die Kollektor-Emitter-Durchbruchsspannung verringert.

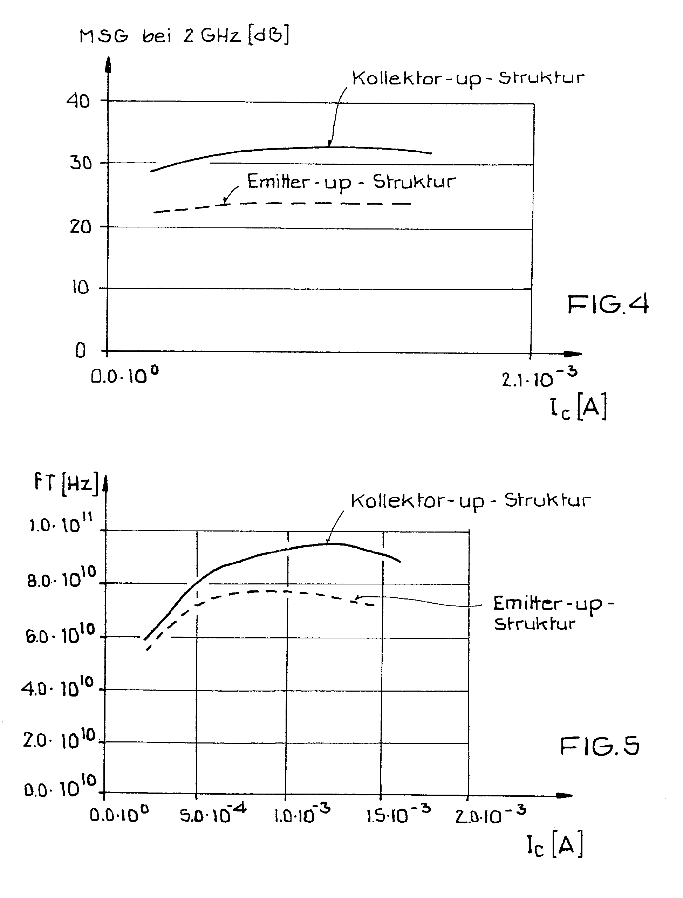

Die Figuren 2 und 3 illustrieren die Gummel-Kurven und die DC Stromverstärkungen für beide Strukturen, wobei die durchgezogenen Kurven der Kollektor-up-Struktur und die gestrichelten Kurven der Emitter-up-Struktur zugeordnet sind.

Da die parasitäre Homo-Sperrschicht zwischen dem Mono-Emitter und einer implantierten externen Basis einen merklichen Einfluss auf den Basisstrom der Emitter-up-Struktur besitzt, wird die Stromverstärkung des Kollektor-up-Transistors verbessert. Alle Simulationen werden im übrigen bei einer Kollektorspannung von 1,5 Volt durchgeführt.

Da eine SIC-Implantation in der Kollektor-up-Struktur nicht verwendet wird, wird eine Kollektor-Basis-Durchschlagsspannung von 11,5 Volt erreicht, während diese für die Emitter-up-Struktur lediglich 9 Volt beträgt. Die zugeordnete Stromverstärkung in der Kollektor-up-Struktur ist größer, wobei die Emitter-Basis-Durchschlagsspannungen beider Strukturen gleich sind und in etwa 2,5 Volt betragen. Eine höhere Kollektor-Basis-Durchschlagsspannung wird in vielen Hochfrequenz-Anwendungen benötigt.

Die Figuren 4, 5 und 6 illustrieren die maximale stabile Verstärkung (Maximum Stable Gain (MAG)) bei 2 GHz, die Durchgangsfrequenz f_{T} und die maximale Oszillationsfrequenz fₘₐₓ sowohl für die Emitter-up-Struktur (gestrichelte Linie) als auch für die Kollektor-up-Struktur (durchgezogene Linie).

Die Kollektor-Basis-Kapazität für beide Strukturen ist von S-Parametern extrahiert und beträgt 1,55 x 10⁻¹⁴ F für den Emitter-up-Transistor und 6,9 x 10⁻¹⁵ F für den Kollektor-up-Transistor. Dies bedeutet eine Verringerung der parasitären Kapazität der erfindungsgemäßen Kollektor-up-Struktur gegenüber der Struktur gemäß dem Stand der Technik um mehr als 55%. Da die Kollektor-Kapazität wirksam verringert wird und der Einfluss des parasitären Homo-Sperrschicht-Transistors in der Kollektor-up-Struktur verringert wird, werden der MSG-Wert um 36%, die Durchgangsfrequenz f_{T} um 23% und die maximale Oszillationsfrequenz fₘₐₓ um 84% jeweils verbessert. Die erhebliche Verbesserung der maximalen Oszillationsfrequenz fₘₐₓ hat ihre Ursache in der Verbesserung der Durchgangsfrequenz f_{T} und in der Verringerung der Kollektor-Basis-Kapazität und des Basis-Widerstandes.

Somit schafft die vorliegende Erfindung ein vorteilhaftes Herstellungsverfahren für einen Bipolartransistor und einen durch ein derartiges Herstellungsverfahren geschaffenen vorteilhaften Bipolartransistor mit einer Kollektor-up-Struktur, wobei das Substrat als auch der Emitter jeweils geerdet ist, so dass eine parasitäre Substratkapazität vermieden wird. Zudem weist die Kollektor-Basis-Sperrschicht eine niedrigere Kapazität als bisher bekannte Bipolartransistoren auf.

Zusätzlich wird der Einfluss des parasitären Substrates minimiert und die Kollektor-Basis-Durchschlagsspannung verbessert, wie in den Simulationskurven gemäß den Figuren 2 bis 6 dargestellt ist. Die Simulationsergebnisse illustrieren ferner erhebliche Verbesserungen des MSG-Wertes, der Durchgangsfrequenz f_{T} und der maximalen Oszillationsfrequenz fₘₐₓ für die Kollektor-up-Struktur, wie oben bereits erläutert, wobei die Kollektor-Emitter-Durchschlagsspannung für beide Varianten, das heißt sowohl für die Kollektor-up- als auch für die Emitter-up-Struktur ungefähr den gleichen Wert annehmen.

Obwohl die vorliegende Erfindung anhand bevorzugter Ausführungsbeispiele vorstehend beschrieben wurde, ist sie darauf nicht beschränkt, sondern auf vielfältige Weise modifizierbar.

### Bezugszeichenliste

- 1: Substrat
- 2: hoch n-dotierter Bereich
- 3: niedrig n-dotierter Bereich
- 4: erste dielektrische Schicht
- 5: Indikationsschicht/erste Nitridschicht
- 6: Kavität
- 7: Kavität
- 8: dielektrische Isolationsschicht
- 9: Aufwachsbereich
- 10: Aufwachsbereich
- 11: hoch p-dotierte Siliziumschicht
- 12: zweite Nitridschichd
- 13: photoresistive Schicht
- 14: aktiver Bereich
- 15: p-dotierter Basisbereich
- 16: niedrig n-dotiertes aufgewachsenes Silizium
- 17: hoch n-dotierter Bereich
- 18: zweite dielektrische Schicht
- 19: dielektrischer Abstandshalter
- 20: dielektrischer Abstandshalter
- 21: Emittermetallisierung
- 22: Basismetallisierung
- 23: Kollektormetallisierung
- 24: Emitter
- 25: Basis
- 26: SIC
- 27: n-dotierte Schicht

## Patentansprüche

1. Verfahren zur Herstellung eines Bipolartransistors mit folgenden Verfahrensschritten:
- Dotieren eines Oberflächenbereiches (3) eines Substrates (1) zum Bilden eines aktiven Emittergebietes mit einer ersten Dotierung;
- Bilden mindestens einer Kavität (6, 7) in dem Substrat (1);
- Aufbringen einer dielektrischen Isolationsschicht (8) auf der Oberfläche der mindestens einen Kavität (6, 7);
- Bilden eines zusammenhängenden Basisbereiches (15) mit einer zweiten Dotierung sowohl in der mindestens einen Kavität (6, 7) zum Vorsehen eines von dem Substrat durch die dielektrische Isolationsschicht (8) elektrisch isolierten Basisanschlussbereiches (15b) als auch zumindest teilweise auf dem gebildeten aktiven Emittergebiet zum Vorsehen eines mit dem Substrat (1) elektrisch verbundenen Basisgebietes (15a); und
- Bilden eines Kollektorgebietes (16) mit einer dritten Dotierung zumindest auf dem gebildeten Basisgebiet (15a) zum Vorsehen eines mit dem gebildeten Basisgebiet (15a) elektrisch verbundenen Kollektors (16, 17).

2. Verfahren nach Anspruch 1,
**dadurch gekennzeichnet,**
**dass** der Basis-Emitter-Übergang und/oder der Basis-Kollektor-Übergang jeweils als Heterostruktur, beispielsweise als Hetero-pn-Übergang zum Bilden eines Hetero-Bipolar-Transistors (HBT) ausgebildet wird, beispielsweise in Form eines Silizium-Germanium-HBTs.

3. Verfahren nach Anspruch 1 oder 2
**dadurch gekennzeichnet,**
**dass** das Substrat (1) als Silizium-Halbleitersubstrat ausgebildet wird.

4. Verfahren nach wenigstens einem der vorhergehenden Ansprüche,
**dadurch gekennzeichnet,**
**dass** ein vorbestimmter Bereich (2) des Substrates (1) unterhalb des dotierten Oberflächenbereiches (3) hoch n-dotiert wird, beispielsweise durch Implantation von Phosphor.

5. Verfahren nach wenigstens einem der vorhergehenden Ansprüche,
**dadurch gekennzeichnet,**
**dass** der Oberflächenbereich (3) des Substrates (1) zum Bilden der ersten Dotierung des Emittergebietes niedrig n-dotiert wird, beispielsweise durch Implantation von Phosphor.

6. Verfahren nach wenigstens einem der vorhergehenden Ansprüche,
**dadurch gekennzeichnet,**
**dass** eine erste dielektrische Schicht (4) über der Substratoberfläche und eine erste Indikationsschicht (5) mit vorbestimmter Dicke, beispielsweise eine Nitridschicht, über der ersten dielektrischen Schicht (4) vor dem Aufbringen der dielektrischen Isolationsschicht (8) gebildet werden.

7. Verfahren nach wenigstens einem der vorhergehenden Ansprüche,
**dadurch gekennzeichnet,**
**dass** das Substrat (1) zum Bilden der mindestens einen Kavität (6, 7) zurückgeätzt wird, beispielsweise mittels eines isotropen Trockenätzverfahrens.

8. Verfahren nach Anspruch 6 oder 7,
**dadurch gekennzeichnet,**
**dass** nach dem Bilden der mindestens einen Kavität (6, 7) die dielektrische Isolationsschicht (8) über dem Substrat (1) zum Bilden der dielektrischen 1solationsschicht (8) auf der Oberfläche der mindestens einen Kavität (6, 7) gebildet wird.

9. Verfahren nach wenigstens einem der Ansprüche 6 bis 8,
**dadurch gekennzeichnet,**
**dass** die erste dielektrische Schicht (4) und die dielektrische Isolationsschicht (8) sowie die Indikationsschicht (5) zum Bilden von Aufwachsbereichen (9, 10) zum Aufwachsen des zusammenhängenden Basisbereiches strukturiert werden.

10. Verfahren nach Anspruch 9,
**dadurch gekennzeichnet,**
**dass** nach dem Bilden der Aufwachsbereiche (9, 10) eine hoch p-dotierte Silizium-Basisschicht mit der zweiten Dotierung über der Anordnung unter Zuhilfenahme der gebildeten Aufwachsbereiche (9, 10) zum Bilden des Basisbereiches (15b) in der mindestens einen Kavität (6, 7) aufgewachsen wird.

11. Verfahren nach Anspruch 10,
**dadurch gekennzeichnet,**
**dass** die aufgewachsene Siliziumschicht (11) und die dielektrische Isolationsschicht (8) bis auf Höhe der ersten Indikationsschicht (5) zurückgeätzt werden, beispielsweise mittels eines CMP-Verfahrens.

12. Verfahren nach wenigstens einem der Ansprüche 6 bis 11
**dadurch gekennzeichnet,**
**dass** die Indikationsschicht (8) und die erste dielektrische Schicht (4) auf dem gebildeten aktiven Emittergebiet (14) entfernt werden, beispielsweise durch vorherige Strukturierung mittels einer photoresistiven Schicht (13).

13. Verfahren nach Anspruch 12,
**dadurch gekennzeichnet,**
**dass** nach dem Entfernen der Indikationsschicht (5) eine p-dotierte Silizium-Germanium-Basisschicht (15) über der Anordnung aufgebracht wird.

14. Verfahren nach Anspruch 13,
**dadurch gekennzeichnet,**
**dass** nach dem Aufwachsen der Silizium-Germanium-Schicht (15) eine n-dotierte Silizium-Kollektorschicht (16) mit der dritten Dotierung über der Anordnung aufgewachsen wird und anschließend bis auf Höhe der Indikationsschicht (5) zurückgeätzt wird, beispielsweise mittels eines isotropen Trockenätzverfahrens.

15. Verfahren nach Anspruch 14,
**dadurch gekennzeichnet,**
**dass** nach dem Aufwachsen der n-dotierten Siliziumschicht (16) eine zweite dielektrische Schicht (18) über der Anordnung aufgebracht wird.

16. Verfahren nach Anspruch 15,
**dadurch gekennzeichnet,**
**dass** nach dem Aufbringen der zweiten dielektrischen Schicht (18) diese bis auf seitliche dielektrische Abstandshalter (19, 20) bis auf Höhe der Indikationsschicht (5) strukturiert entfernt wird, beispielsweise mittels eines isotropen Trockenätzverfahrens.

17. Verfahren nach Anspruch 16,
**dadurch gekennzeichnet,**
**dass** geeignete Metallisierungen und/oder Salizidierung (21, 22, 23) zum Bilden von Anschlusskontakten des Emitters, der Basis und des Kollektors unter Zuhilfenahme der seitlichen dielektrischen Abstandshalter (19, 20) gebildet werden.

18. Verfahren nach wenigstens einem der Ansprüche 10 bis 17
**dadurch gekennzeichnet,**
**dass** die direkt auf dem Substrat (1) aufgewachsene hoch p-dotierte Siliziumschicht silizidiert wird, beispielsweise mittels Implantation von Phosphor.

19. Bipolartransistor mit:
- einem Substrat (1), von welchem ein Oberflächenbereich (3) zum Bilden eines aktiven Emittergebietes mit einer ersten Dotierung dotiert ist;
- mindestens einer in dem Substrat (1) gebildeten Kavität (6, 7);
- einer auf der Oberfläche der mindestens einen Kavität (6, 7) aufgebrachten dielektrischen Isolationsschicht (8);
- einem zusammenhängenden Basisbereich (15) mit einer zweiten Dotierung, welcher sowohl in der mindestens einen Kavität (6, 7) zum Bilden eines von dem Substrat (1) durch die dielektrische Isolationsschicht (8) elektrisch isolierten Basisanschlussbereiches (15b) als auch zumindest teilweise auf dem gebildeten aktiven Emittergebiet zum Vorsehen eines mit dem Substrat (1) elektrisch verbundenen Basisgebietes (15a) gebildet ist; und mit
- einem Kollektorgebiet (16) mit einer dritten Dotierung, welches auf dem gebildeten Basisgebiet (15a) zum Bilden eines mit dem gebildeten Basisgebiet (15a) elektrisch verbundenem Kollektors (16, 17) gebildet ist.

20. Bipolartransistor nach Anspruch 19,
**dadurch gekennzeichnet,**
**dass** der Basis-Emitter-Übergang und/oder der Basis-Kollektor-Übergang jeweils als Heterostruktur, beispielsweise als Hetero-pn-Übergang zum Bilden eines Hetero-Bipolar-Transistors (HBT), beispielsweise in Form eines Silizium-Germanium-HBTs, ausgebildet sind.

21. Bipolartransistor nach Anspruch 19 oder 20,
**dadurch gekennzeichnet,**
**dass** das Substrat (1) als Silizium-Halbleitersubstrat ausgebildet ist.

22. Bipolartransistor nach wenigstens einem der Ansprüche 19 bis 21,
**dadurch gekennzeichnet,**
**dass** ein vorbestimmter Bereich (2) des Substrates (1) unterhalb des dotierten Oberflächenbereiches (3) hoch n-dotiert ist, beispielsweise durch Implantation von Phosphor.

23. Bipolartransistor nach wenigstens einem der Ansprüche 19 bis 22,
**dadurch gekennzeichnet,**
**dass** der Oberflächenbereich (3) des Substrates (1) zum Bilden der ersten Dotierung des Emittergebietes niedrig n-dotiert ist, beispielsweise durch Implantation von Phosphor.

24. Bipolartransistor nach wenigstens einem der Ansprüche 19 bis 23,
**dadurch gekennzeichnet,**
**dass** eine erste dielektrische Schicht (4) über der Substratoberfläche und eine erste Indikationsschicht (5), beispielsweise eine Nitridschichd, mit vorbestimmter Dicke über der ersten dielektrischen Schicht (4) vor dem Aufbringen der dielektrischen Isolationsschicht (8) gebildet sind.

25. Bipolartransistor nach wenigstens einem der Ansprüche 19 bis 24,
**dadurch gekennzeichnet,**
**dass** das Substrat (1) zum Bilden der mindestens einen Kavität (6, 7) zurückgeätzt ist, beispielsweise mittels eines isotropen Trockenätzverfahrens.

26. Bipolartransistor nach Anspruch 24 oder 25,
**dadurch gekennzeichnet,**
**dass** nach dem Bilden der mindestens einen Kavität (6, 7) die dielektrische Isolationsschicht (8) über dem Substrat (1) zum Bilden der dielektrischen Isolationsschicht (8) auf der Oberfläche der mindestens einen Kavität (6, 7) gebildet ist.

27. Bipolartransistor nach wenigstens einem der Ansprüche 24 bis 26,
**dadurch gekennzeichnet,**
**dass** die erste dielektrische Schicht (4) und die dielektrische Isolationsschicht (8) sowie die Indikationsschicht (5) zum Bilden von Aufwachsbereichen (9, 10) zum Aufwachsen des zusammenhängenden Basisbereiches strukturiert sind.

28. Bipolartransistor nach Anspruch 27,
**dadurch gekennzeichnet,**
**dass** nach dem Bilden der Aufwachsbereiche (9, 10) eine hoch p-dotierte Silizium-Basisschicht mit der zweiten Dotierung über der Anordnung unter Zuhilfenahme der gebildeten Aufwachsbereiche (9, 10) zum Bilden des Basisbereiches (15b) in der mindestens einen Kavität (6, 7) aufgewachsen ist.

29. Bipolartransistor nach Anspruch 28,
**dadurch gekennzeichnet,**
**dass** die aufgewachsene Siliziumschicht (11) und die dielektrische Isolationsschicht (8) bis auf Höhe der ersten Indikationsschicht (5) zurückgeätzt sind, beispielsweise mittels eines CMP-Verfahrens.

30. Bipolartransistor nach wenigstens einem der Ansprüche 24 bis 29,
**dadurch gekennzeichnet,**
**dass** die Indikationsschicht (8) und die erste dielektrische Schicht (4) auf dem gebildeten aktiven Emittergebiet (14) entfernt sind, beispielsweise durch vorherige Strukturierung mittels einer photoresistiven Schicht (13).

31. Bipolartransistor nach Anspruch 30,
**dadurch gekennzeichnet,**
**dass** nach dem Entfernen der Indikationsschicht (5) eine p-dotierte Silizium-Germanium-Basisschicht (15) über der Anordnung aufgebracht ist.

32. Bipolartransistor nach Anspruch 31,
**dadurch gekennzeichnet,**
**dass** nach dem Aufwachsen der Silizium-Germanium-Schicht (15) eine n-dotierte Silizium-Kollektorschicht (16) mit der dritten Dotierung über der Anordnung aufgewachsen und anschließend bis auf Höhe der Indikationsschicht (5) zurückgeätzt ist, beispielsweise mittels eines isotropen Trockenätzverfahrens.

33. Bipolartransistor nach Anspruch 32,
**dadurch gekennzeichnet,**
**dass** nach dem Aufwachsen der n-dotierten Siliziumschicht (16) eine zweite dielektrische Schicht (18) über der Anordnung aufgebracht ist.

34. Bipolartransistor nach Anspruch 33,
**dadurch gekennzeichnet,**
**dass** nach dem Aufbringen der zweiten dielektrischen Schicht (18) die zweite dielektrische Schicht (18) bis auf seitliche dielektrische Abstandshalter (19, 20) bis auf Höhe der Indikationsschicht (5) strukturiert entfernt ist, beispielsweise mittels eines isotropen Trockenätzverfahrens.

35. Bipolartransistor nach Anspruch 34,
**dadurch gekennzeichnet,**
**dass** geeignete Metallisierungen und/oder Salizidierungen (21, 22, 23) zum Bilden von Anschlusskontakten des Emitters, der Basis und des Kollektors unter Zuhilfenahme der seitlichen dielektrischen Abstandshalter (19, 20) gebildet sind.

36. Bipolartransistor nach wenigstens einem der Ansprüche 28 bis 35,
**dadurch gekennzeichnet,**
**dass** die direkt auf dem Substrat (1) aufgewachsene hoch p-dotierte Siliziumschicht silizidiert ist, beispielsweise mittels Implantation von Phosphor.
